# FASCICULE DE BREVET EUROPEEN

(11) **EP 2 299 790 B1**
(45) Date de publication et mention de la délivrance du brevet: **22.10.2014**
(21) Numéro de dépôt: 10176299.5
(22) Date de dépôt: 10.09.2010
(51) Int. Cl.: H05K 1/02, H01P 5/08

(54) **Dispositif de raccordement pour signaux haute fréquence entre un connecteur et une ligne de transmission**
Verbindungsanordnung für Hochfrequenzsignale zwischen einem Verbindungsstecker und einer Übertragungsbahn
Connecting device for high frequency signals between a connector and a signal transmission track

(30) Priorité: 11.09.2009 FR 0904347
(43) Date de publication de la demande: 23.03.2011
(73) Titulaire: Thales, 92200 Neuilly Sur Seine (FR); Groupe des Ecoles des Telecommunications/ Ecole Nationale Superieure de Telecommunications De Bretagne, 29238 Brest Cedex 3 (FR)
(72) Inventeur: Cornic, Pascal, 29200 Brest (FR); Coupez, Jean-Philippe, 29480 Le Relecq Kerhuon (FR); Hemery, Jérémie, 29140 Tourc'h (FR); Boucher, Julien, 29450 Commana (FR)
(74) Mandataire: Collet, Alain

(56) Documents cités:
- WO-A2-2008/024411
- US-A- 4 837 529
- US-A1- 2005 146 390
- US-A1- 2006 208 835
- US-A1- 2009 056 999
- LIU Q H ET AL: "A Coaxial-to-Microstrip Transition for Multilayer Substrates", IEEE TRANSACTIONS ON MICROWAVE THEORY AND TECHNIQUES, IEEE SERVICE CENTER, PISCATAWAY, NJ, US LNKD- DOI:10.1109/TMTT.2003.821936, vol. 52, no. 2, 1 février 2004 (2004-02-01), pages 584-588, XP011107716, ISSN: 0018-9480

## Description

L'invention concerne un dispositif de raccordement pour signaux haute fréquence comprenant un circuit imprimé sur une face externe duquel est imprimé une ligne de transmission et un connecteur coaxial monté en surface du circuit imprimé sur la face externe. L'invention trouve une utilité particulière pour la transmission de signaux radiofréquence en bande X, en particulier pour des fréquences de 9 à 10 GHz. Il est bien entendu que l'invention peut s'appliquer à d'autres bandes de fréquence.

Pour véhiculer des signaux haute fréquence on utilise, par exemple, une technologie dite micro ruban réalisée sur circuit imprimé. Des pistes conductrices imprimées sont réalisées sur des faces du circuit imprimé. Ces faces peuvent être externes ou internes et peuvent être séparées par un ou plusieurs plans conducteurs ou plans de masse. Les lignes micro rubans ont des dimensions particulières de telle sorte que, une fois associées aux plans conducteurs elles forment des lignes adaptées en impédance. Cette adaptation permet d'assurer une certaine transparence de la ligne vis-à-vis du signal véhiculé. En d'autres termes, on cherche à réduire au maximum les pertes de puissance électrique du signal tout au long de la ligne.

Pour véhiculer les signaux haute fréquence hors du circuit imprimé, on utilise, par exemple, des connecteurs coaxiaux permettant de raccorder les lignes micro rubans à des câbles coaxiaux dont les impédances sont également adaptées. On trouve des connecteurs destinés à être montés en surface, comme par exemple décrit dans le document US 2006/0208835. Ce type de montage ne nécessite pas de trou métallisé dans lequel serait piqué un contact du connecteur. Plus précisément, ces connecteurs sont raccordés au circuit imprimé par report de zones plates du connecteur sur des plages externes du circuit imprimé. Le raccordement peut s'effectuer au moyen d'une colle conductrice ou d'une pâte à braser interposée entre les zones plates et les plages correspondantes. Le circuit imprimé sur lequel sont posés les composants, tels que les connecteurs, est immergé dans une cuve où un fluide chaud, généralement en phase vapeur, permet de braser les composants.

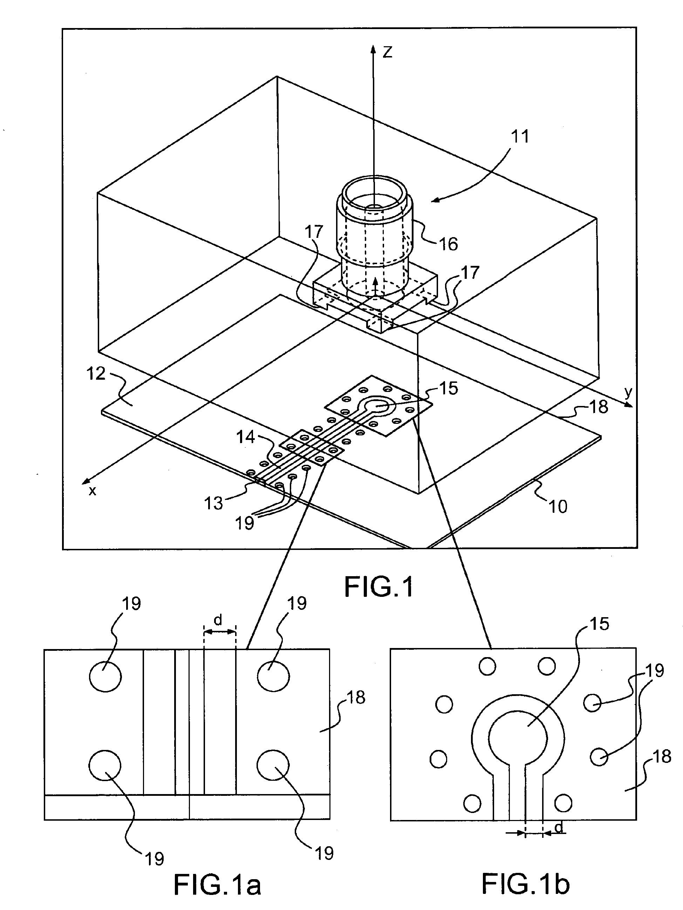

La figure 1 illustre une réalisation d'un circuit imprimé 10 destiné à recevoir un connecteur 11 sur une de ses faces externes 12. Cette réalisation a été mise en oeuvre par le déposant sans être divulguée. Sur cette face une ligne de transmission 13, réalisée sous forme d'une ligne micro ruban comprend une partie rectiligne 14 terminée par un plot circulaire 15 dont le diamètre est plus grand que la largeur de la partie rectiligne 14. La largeur de la partie rectiligne 14 est définie de façon à ce que la ligne de transmission ait une impédance déterminée, par exemple 50 Ohms. Cette impédance dépend de la composition et des dimensions du circuit imprimé 10. Par exemple, le circuit imprimé comprend un substrat isolant de permittivité relative εᵣ égale à 3,38, le substrat séparant la face externe 12 d'un plan de masse interne situé en regard de la ligne de transmission 13. Le plan de masse interne n'est pas visible sur la figure 1. Pour obtenir une impédance de 50 Ohms, on choisit par exemple une largeur de la partie rectiligne 14 de 450 µm et une épaisseur du substrat de 203 µm. Le diamètre du plot 15 est quant à lui imposé par le diamètre de la zone plate de l'âme du connecteur 11. Sur la figure 1, l'âme n'est pas visible. Elle est masquée par le corps 16 du connecteur 11. Ce corps 16 est raccordé par des zones plates 17 sur un plan de masse 18 réalisé sur la face externe 12 et entourant la ligne de transmission 13. Dans l'exemple représenté, le diamètre du plot 15 est de 1,7 mm. Des trous métallisés ou vias 19 permettent de raccorder le plan de masse 18 au plan de masse interne. Le plan de masse 18 est disposé à distance de la ligne de transmission 13 de façon à ce que son interaction avec la ligne de transmission 13 ne modifie pas ou que de façon négligeable l'impédance de la ligne de transmission 13 tout en assurant le blindage de celle ci. Les bords du plan de masse 18 sont par exemple situés à une distance d de 500 µm de la ligne de transmission 13. Le plan de masse 18 permet notamment une reprise de masse plus aisée pour les composants montés en surface, en particulier pour le connecteur 11. Le plan de masse 18 assure également une forte isolation électrique entre les différents motifs imprimés sur la face externe 12.

Les figures 1a et 1b représentent des vues agrandies de la ligne de transmission 13 dans le plan de celle-ci. La figure 1a représente une portion de la partie rectiligne 14. Tout au long de cette partie, la distance d est constante. La figure 1b représente la ligne de transmission 13 au niveau de son plot 15. La distance d, définie pour la partie rectiligne 14, est conservée autour du plot 15.

Un raccordement du connecteur 11 avec une structure multicouches, tel qu'illustré sur la figure 1, présente des effets électriques parasites, qui viennent particulièrement casser la transparence du connecteur vis à vis du signal véhiculé. Cette transparence est surtout dégradée en haute fréquence. Ces effets, notamment liés au caractère capacitif intrinsèque du plot 15, entraînent alors une désadaptation et des pertes d'insertion plus ou moins importantes sur le signal.

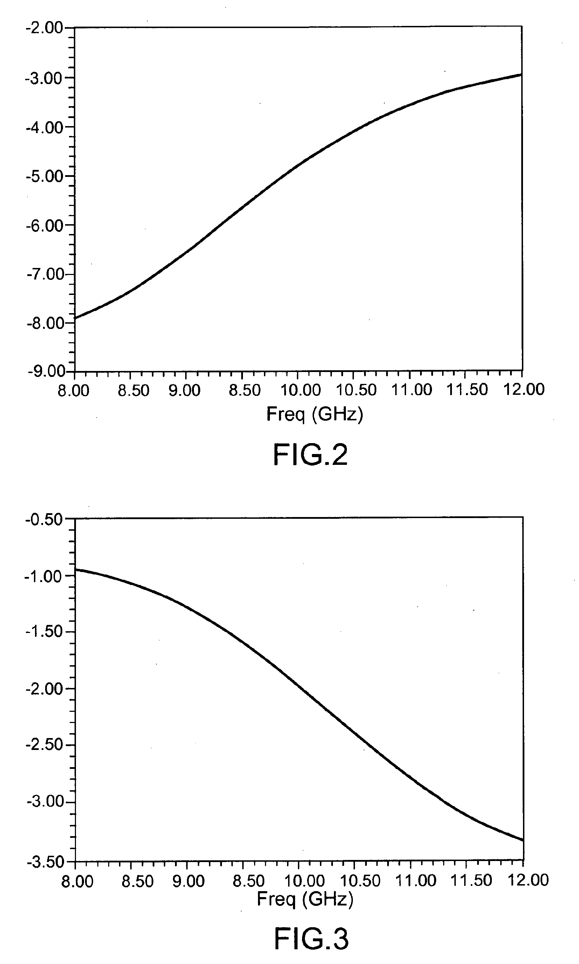

La figure 2 représente le niveau d'adaptation S11 de l'exemple représenté sur la figure 1 exprimé en dB en fonction de la fréquence du signal véhiculé par la ligne de transmission 13 et le connecteur 11. Le niveau d'adaptation illustre la puissance électrique réfléchie. Toujours pour cet exemple, la figure 3 représente le niveau d'insertion S21 ou pertes d'insertion exprimé en dB en fonction de la fréquence du signal. Le niveau d'insertion illustre les pertes de puissance électrique en transmission au niveau du raccordement entre la ligne de transmission 13 et le connecteur 11.

On constate, dans ce cas, que ce raccordement présente un niveau d'adaptation de -6 dB pour une fréquence utile de travail de 9,3 GHz, et des pertes d'insertion de 1,5 dB pour cette même fréquence. Etant donné ces résultats, le raccordement est loin d'être optimal.

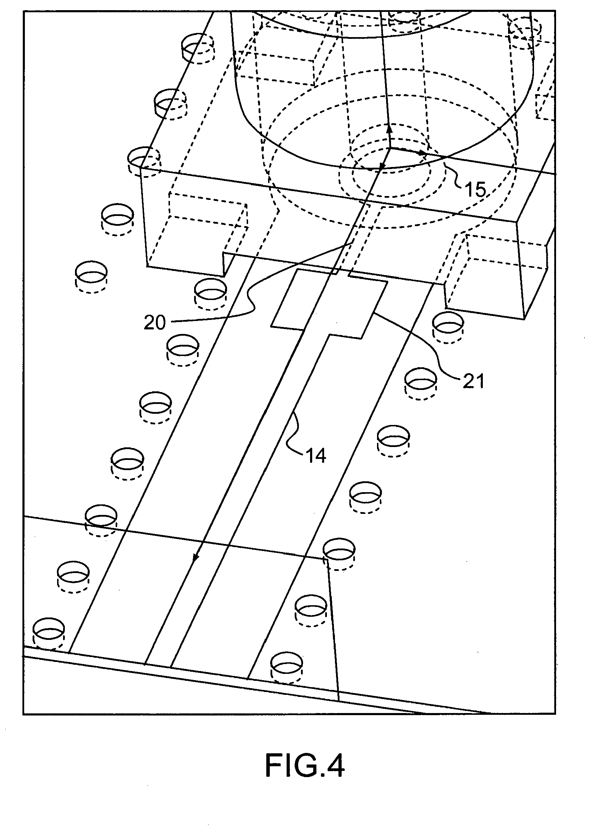

Pour améliorer la transparence de ce raccordement, le déposant a proposé de corriger cette désadaptation. Un exemple de réalisation de cette correction est représenté sur la figure 4. La ligne de transmission 13 comprend au voisinage du plot 15 un tronçon de ligne inductive 20 et un tronçon de ligne capacitive 21 permettant de réaliser un élément de filtrage de type passe bas en coopération avec l'impédance apportée par la transition entre le connecteur 11 et le plot 15. Le tronçon de ligne inductive 20 est formé d'une ligne micro ruban dont la largeur est inférieure à celle de la partie rectiligne 14. Le tronçon de ligne capacitive 21 est formé d'un plot de forme carrée dont la dimension du côté est supérieure à la largeur de la partie rectiligne 14. Le tronçon de ligne inductive 20 est disposé entre le plot 15 et le tronçon de ligne capacitive 21. En première approche, les différents éléments électriques de la transition, associés à des valeurs d'impédance à une fréquence donnée forment une cellule de filtre passe bas en π comprenant une inductance, le tronçon de ligne inductive 20, disposée entre deux capacités, le tronçon de ligne capacitive 21 et le plot 15. La dimension du plot 15 est imposée par le connecteur 11 et les dimensions des impédances 20 et 21 sont adaptées pour obtenir la meilleure transparence de la transition à la fréquence considérée en fonction des caractéristiques du circuit imprimé 10, épaisseur et permittivité du substrat.

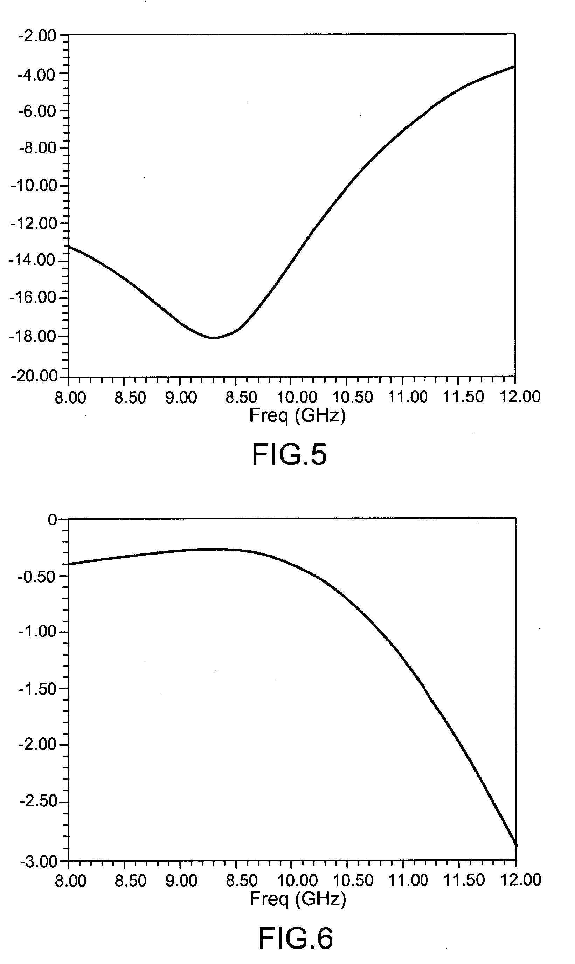

La figure 5 représente le niveau d'adaptation S11 de l'exemple représenté sur la figure 4 exprimé en dB en fonction de la fréquence du signal véhiculé par la ligne de transmission 13 et le connecteur 11. Toujours pour cet exemple, la figure 6 représente les pertes d'insertion exprimées en dB en fonction de la fréquence du signal. On constate, dans ce cas, que cette transition présente un niveau d'adaptation d'environ -18 dB pour une fréquence utile de travail de 9,3 GHz, et des pertes d'insertion de 0,27 dB pour cette même fréquence. On constate que la correction apportée améliore nettement la transparence de la transition. Néanmoins, les résultats obtenus présentent un caractère relativement faible bande autour de la fréquence de travail. Il est donc nécessaire de modifier le dessin du circuit imprimé pour tout changement, même faible, de fréquence de travail. De plus, la qualité de la correction ainsi obtenue est très sensible aux tolérances de fabrication du circuit imprimé et de positionnement du connecteur sur le circuit imprimé. Autrement dit, on risque d'obtenir des aléas importants sur la qualité de la correction entre deux circuits imprimés fabriqués selon le même dessin.

L'invention vise à améliorer la transparence d'une transition entre un circuit imprimé et un connecteur coaxial pour une utilisation en haute fréquence. L'invention a pour but d'obtenir la transparence souhaitée pour une largeur de bande importante autour d'une fréquence de travail donnée.

A cet effet, l'invention a pour objet un dispositif de raccordement pour signaux haute fréquence, comprenant un circuit imprimé sur une face externe duquel est imprimé une ligne de transmission et un connecteur coaxial monté en surface du circuit imprimé sur la face externe, la ligne de transmission étant raccordée au connecteur au moyen d'un plot appartenant à la ligne de transmission sur lequel est rapportée une âme centrale du connecteur, le circuit imprimé comprenant au moins un plan de masse interne parallèle à la face externe et contribuant à l'adaptation de la ligne de transmission, **caractérisé en ce que** le plan de masse est ajouré au moyen d'une épargne en regard du plot.

Le montage en surface de l'âme du connecteur est réalisé sans trou métallisé et donc sans connexion à des couches internes du circuit imprimé.

Le fait d'ajourer le plan de masse permet de réduire l'impédance apportée par le plot. On améliore ainsi la transparence de la transition entre la ligne de transmission et le connecteur.

L'invention sera mieux comprise et d'autres avantages apparaîtront à la lecture de la description détaillée d'un mode de réalisation donné à titre d'exemple, description illustrée par le dessin joint dans lequel :
la figure 1 représente un exemple de réalisation d'un circuit imprimé destiné à recevoir un connecteur sur une de ses faces externes ;
la figure 2 représente le niveau d'adaptation S11 de l'exemple représenté sur la figure 1 ;
la figure 3 représente le niveau d'insertion S21 ou pertes d'insertion de l'exemple représenté sur la figure 1 ;
la figure 4 représente un exemple de correction appliqué au circuit imprimé de la figure 1 ;
la figure 5 représente le niveau d'adaptation S11 de l'exemple représenté sur la figure 4 ;
la figure 6 représente le niveau d'insertion S21 ou pertes d'insertion de l'exemple représenté sur la figure 4 ;
la figure 7 représente en coupe un exemple de réalisation d'un circuit imprimé conforme à l'invention ;
la figure 8 représente en perspective le circuit imprimé de la figure 7 complété d'une correction d'impédance ;
la figure 9 représente le niveau d'adaptation S11 de l'exemple représenté sur la figure 8 ;
la figure 10 représente le niveau d'insertion S21 ou pertes d'insertion de l'exemple représenté sur la figure 8 ;
la figure 11 représente en perspective une variante de réalisation d'un circuit imprimé conforme à l'invention ;
la figure 12 représente la variante de la figure 11 vue perpendiculairement au circuit imprimé.

Par souci de clarté, les mêmes éléments porteront les mêmes repères dans les différentes figures.

Les figures 1 à 6 ont déjà été décrites pour présenter l'invention.

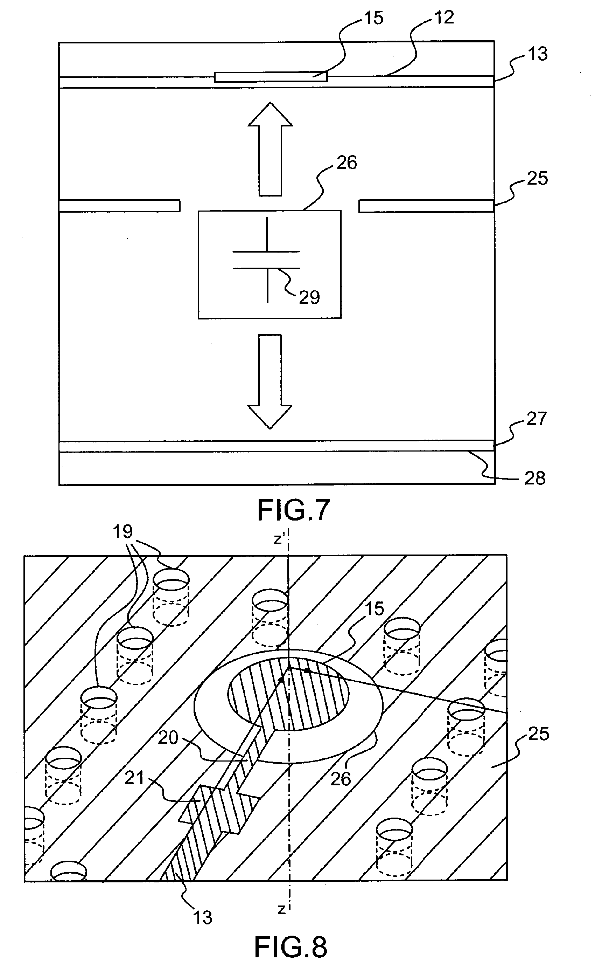

La figure 7 représente en coupe le circuit imprimé 10 dans lequel on retrouve sur sa face externe 12 la ligne de transmission 13 et son plot 15. Le plan de masse interne porte ici le repère 25 et contribue à l'adaptation de la ligne de transmission 13. Selon l'invention, le plan de masse interne 25 comprend une épargne 26 situés en regard du plot 15. En l'absence d'épargne, la présence du plot 15 en regard du plan de masse 25 crée une désadaptation de la ligne de transmission 13. L'épargne permet de réduire cette désadaptation.

Avantageusement, le circuit imprimé 10 comprend un second plan de masse 27, parallèle au plan de masse interne 25. Le plan de masse interne 25 est situé entre la ligne de transmission 13 et le second plan de masse 27 qui peut être disposé sur une seconde face externe 28 du circuit imprimé 10. Le second plan de masse 27 assure un blindage de l'ensemble adapté formé par la ligne de transmission 13 et le plan de masse interne 25. Le second plan de masse 27 est continu en regard du plot 15. Autrement dit le second plan de masse 27 n'est pas ajouré en regard du plot 15. Le second plan de masse 27 forme donc avec le plot 15 une impédance essentiellement capacitive. Cette impédance symbolisée par une capacité 29 est inférieure à celle obtenue en l'absence d'épargne 26 entre le plan de masse 25 et le plot 15. La présence du plan de masse 27 permet de fermer électromagnétiquement le circuit imprimé 10 en regard du plot 15 et donc de maîtriser l'impédance du raccordement du connecteur 11 et de la ligne de transmission 13 au moyen de la capacité 29.

La figure 8 représente en perspective la ligne de transmission 13 et le plan de masse interne 25. Le plot 15 et l'épargne 26 sont tous deux circulaires et centrés sur un même axe zz' perpendiculaire aux différents plans du circuit imprimé 10. Pour ne pas surcharger la figure le plan de masse 18 n'est pas représenté. Seuls les vias 19 raccordant le plan de masse 18 au plan de masse interne 25 apparaissent sur la figure 8. Les vias 19 peuvent également être raccordés au plan de masse 27 pour imposer une même référence de masse localement au niveau de chaque via 19.

Avantageusement, le diamètre de l'épargne 26 est supérieur à celui du plot 15 de façon à limiter l'impédance générée entre le plot 15 et le plan de masse interne 25. Par exemple pour un plot 15 de 1,7 mm de diamètre on réalise une épargne 26 de 2,7 mm de diamètre. Ainsi dans l'impédance de la transition entre la ligne de transmission 13 et l'âme du connecteur 11, l'interaction du plot 15 et du plan de masse 27 est prépondérante par rapport à l'interaction du plot 15 et du plan de masse interne 25. Le diamètre de l'épargne 26 ne doit toutefois pas être trop important pour conserver son interaction avec la ligne de transmission dans sa partie rectiligne 14.

L'impédance de la transition est réduite par rapport à celle obtenue dans la réalisation de la figure 1. Toutefois, La transparence n'est pas parfaite et il est possible de la corriger au voisinage du plot 15 en plaçant dans la ligne de transmission un tronçon de ligne inductive 20 et un tronçon de ligne capacitive 21 permettant de réaliser une cellule de filtrage de type passe bas en coopération avec l'impédance apportée par le raccordement entre l'âme centrale du connecteur 11 et le plot 15. Les repères 20 et 21 ont été repris de la figure 4. En effet, les tronçons de ligne inductive 20 et capacitive 21 remplissent la même fonction. Il est toutefois important de noter que les valeurs d'impédance apportées dans la figure 8 par les deux tronçons de ligne 20 et 21 sont inférieures à celles apportées dans la figure 4. Ceci permet d'obtenir un filtrage plus large bande pour la réalisation de la figure 8. Cette largeur de bande est importante pour la reproductibilité de la transparence de la transition. On a en effet constaté qu'avec des tolérances de fabrication semblables pour le circuit imprimé 10 et pour le positionnement du connecteur 11 sur le circuit imprimé 10, la transparence de la transition définie à la figure 8 évolue dans une fourchette bien plus faible que pour la transition définie à la figure 4.

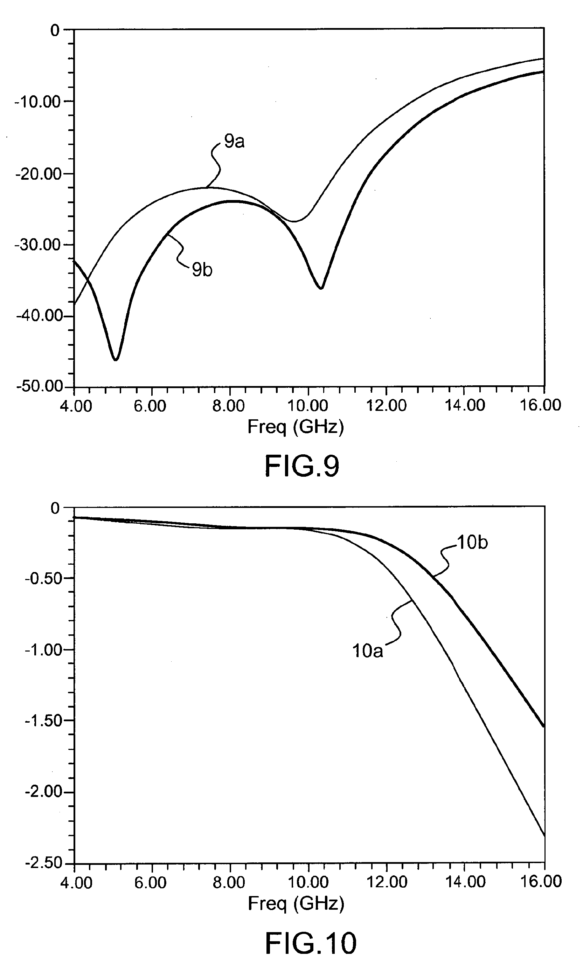

A titre d'exemple, la figure 9 représente le niveau d'adaptation S11 de l'exemple représenté sur la figure 8 exprimé en dB en fonction de la fréquence du signal véhiculé par la ligne de transmission 13 et le connecteur 11. Toujours pour cet exemple, la figure 10 représente les pertes d'insertion exprimées en dB en fonction de la fréquence du signal. Les valeurs numériques proposées pour les figures 1 à 6 ont été reprises pour le mode de réalisation dont la structure est représentée sur les figures 7 et 8. Le circuit imprimé comprend deux substrats isolants de permittivité relative εᵣ égale à 3,38, le substrat séparant la face externe 12 du plan de masse interne 25 a une épaisseur de 203 µm et le substrat séparant le plan de masse interne 25 du plan de masse 27 a une épaisseur de 406 µm.

Deux exemples de correction ont été illustrés sur les figures 9 et 10 en fonction de la longueur du tronçon de ligne inductive 20. Sur la figure 9, une courbe 9a représente le niveau d'adaptation pour une longueur de la ligne inductive 20 de 1600 µm et une courbe 9b représente le niveau d'adaptation pour une longueur de 1200 µm. Pour une fréquence utile de travail de 9,3 GHz, le niveau d'adaptation est d'environ -26 dB dans les deux exemples de correction. De même pour la figure 10 une courbe 10a représente les pertes d'insertion pour une longueur de 1600 µm et une courbe 10b pour une longueur de 1200 µm. Toujours pour une fréquence utile de travail de 9,3 GHz, les pertes d'insertion sont de 0,15 dB pour les deux exemples de correction.

La mise en oeuvre conjointe de l'épargne 26 et d'une correction de type passe-bas permet d'obtenir un excellent niveau de performances de la transition entre le connecteur 11 et la ligne de transmission 13 sur une largeur de bande très significative. Il est bien entendu que les exemples numériques proposés ci-dessus doivent être adaptés par des essais en fonction de la fréquence centrale utile de travail.

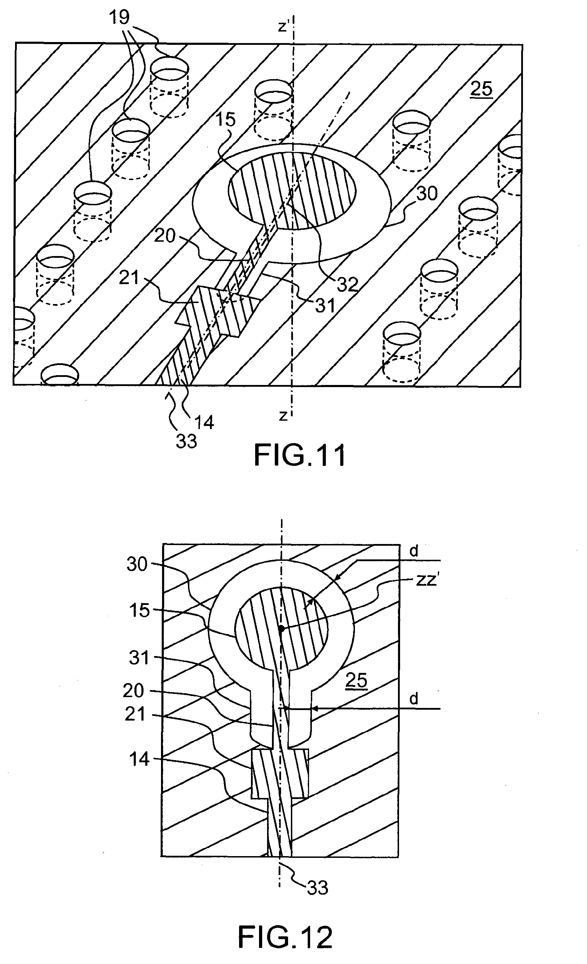

Dans les exemples de correction illustrés précédemment, la largeur du tronçon de ligne inductive 20 est de 200 µm. Cette largeur est plus faible que la largeur de la partie rectiligne 14 qui est de 450 µm afin d'obtenir un effet inductif. Cette réduction de largeur tend également à s'opposer au passage du signal dans la ligne de transmission 13. On peut limiter cet inconvénient en modifiant la forme de l'épargne 26. Le plot 15 conserve sa forme circulaire centré sur l'axe zz', forme imposée par le choix du connecteur 11. Une variante de forme d'épargne 26 permettant de limiter cet inconvénient est illustré sur la figure 11. Plus précisément, l'épargne 26 comprend une partie circulaire 30 centrée sur l'axe zz' et une partie allongée 31 s'étendant selon un second axe 32 parallèle à une direction principale 33 de la partie rectiligne 14 de la ligne de transmission 13 en contact avec le plot 15.

Cette variante n'exclut pas le fait de mettre en oeuvre une correction utilisant des tronçons de ligne inductif 20 et capacitif 21. On a néanmoins constaté que le fait de ne pas avoir localement de plan de masse sous le tronçon de ligne inductif 20 permet d'améliorer fortement le caractère inductif recherché pour cet élément. En conséquence, à largeur de ligne inductive donnée, le tronçon de ligne inductif 20 sera, par exemple, de longueur plus petite que dans le cas de la figure 8 et donc de caractère plus localisé. La partie allongée 31 peut s'étendre uniquement en regard du tronçon de ligne inductif 20.

La figure 12 représente la variante de la figure 11 vue perpendiculairement au circuit imprimé 10. Avantageusement, une projection de la ligne de transmission, sur le plan masse interne 25, conserve une distance d sensiblement constante par rapport au bord de l'épargne 26, la distance d étant mesurée d'une part entre le plot 15 et la partie circulaire 30 de l'épargne 26 et d'autre part entre la partie rectiligne 14 de ligne de transmission 13 et le bord de l'épargne 26 perpendiculairement à la direction principale 33 de la partie rectiligne 14. Si la partie allongée 31 s'étend uniquement en regard du tronçon de ligne inductif 20, pour cette partie 31, la distance d est mesurée entre le bord de l'épargne 26 et le tronçon de ligne inductif 20.

## Revendications

1. Dispositif de raccordement pour signaux haute fréquence, comprenant un circuit imprimé (10) sur une face externe (12) duquel est imprimé une ligne de transmission (13) et un connecteur (11) coaxial monté en surface du circuit imprimé (10) sur la face externe (12), le raccordement du connecteur (11) au circuit imprimé (10) se faisant par report de zones plates du connecteur (11) sur des plages externes du circuit imprimé sans trou métallisé, la ligne de transmission (13) étant raccordée au connecteur (11) au moyen d'un plot (15) appartenant à la ligne de transmission (13) sur lequel est rapporté une âme centrale du connecteur (11), le circuit imprimé (10) comprenant au moins un plan de masse interne (25) parallèle à la face externe (12) et contribuant à l'adaptation de la ligne de transmission (13), **caractérisé en ce que** le plan de masse interne (25) est ajouré au moyen d'une épargne (26) en regard du plot (15).

2. Dispositif selon la revendication 1, **caractérisé en ce que** le circuit imprimé (10) comprend un second plan de masse (27), parallèle au plan de masse interne (25), le plan de masse interne (25) étant situé entre la ligne de transmission (13) et le second plan de masse (27), et **en ce que** le second plan de masse (27) est continu en regard du plot (15).

3. Dispositif selon l'une des revendications précédentes, **caractérisé en ce que** la ligne de transmission (13) comprend au voisinage du plot (15) une cellule de filtrage de type passe bas en coopération avec l'impédance apportée par la transition entre l'âme centrale du connecteur (11) et le plot (15).

4. Dispositif selon la revendication 3, **caractérisé en ce que** la cellule de filtrage comprend un tronçon de ligne inductive (20) et un tronçon de ligne capacitive (21).

5. Dispositif selon l'une des revendications précédentes, **caractérisé en ce que** le plot (15) est circulaire centré sur un axe (zz') et **en ce que** l'épargne (26) est circulaire et centrée sur le même axe (zz').

6. Dispositif selon la revendication 5, **caractérisé en ce que** le diamètre de l'épargne (26) est supérieur à celui du plot (15) de façon à limiter l'impédance générée entre le plot (15) et le plan de masse interne (25).

7. Dispositif selon l'une quelconques des revendications 1 à 4, **caractérisé en ce que** le plot (15) est circulaire centré sur un axe (zz') et **en ce que** l'épargne (26) comprend une partie circulaire (30) centrée sur le même axe (zz') et une partie allongée (31) s'étendant selon un second axe (32) parallèle à une direction principale (33) d'une partie rectiligne (14) de la ligne de transmission (13) en contact avec le plot (15).

8. Dispositif selon la revendication 7, **caractérisé en ce que** sur le plan de masse interne (25), une projection de la ligne de transmission (13) conserve une distance (d) sensiblement constante par rapport au bord de l'épargne (26), la distance (d) étant mesurée d'une part entre le plot (15) et la partie circulaire (30) de l'épargne (26) et d'autre part entre la partie rectiligne (14) de ligne de transmission (13) et le bord de l'épargne (26) perpendiculairement à la direction principale (33) de la partie rectiligne (14).

## Patentansprüche

1. Verbindungsvorrichtung für Hochfrequenzsignale, die einen gedruckten Schaltkreis (10), wobei auf einer Außenseite (12) desselben eine Übertragungsbahn (13) gedruckt ist, und einen koaxialen Verbindungsstecker (11), der auf der Oberfläche des gedruckten Schaltkreises (10) auf der Außenseite (12) montiert ist, umfasst, wobei die Verbindung des Verbindungssteckers (11) mit dem gedruckten Schaltkreis (10) durch Übertrag flacher Zonen des Verbindungssteckers (11) auf externe Bereiche des gedruckten Schaltkreises ohne metallisiertes Loch erfolgt, wobei die Übertragungsbahn (13) mit dem Verbindungsstecker (11) anhand eines Steckplatzes (15) verbunden ist, der zur Übertragungsbahn (13) gehört, auf dem eine zentrale Seele des Verbindungssteckers (11) angebracht ist, wobei der gedruckte Schaltkreis (10) mindestens einen internen Masseplan (25) parallel zur Außenseite (12) umfasst und zur Anpassung der Übertragungsbahn (13) beiträgt, **dadurch gekennzeichnet, dass** der interne Masseplan (25) anhand einer Aussparung (26) gegenüber dem Steckplatz (15) durchbrochen ist.

2. Vorrichtung nach Anspruch 1, **dadurch gekennzeichnet, dass** der gedruckte Schaltkreis (10) einen zweiten Masseplan (27) parallel zum internen Masseplan (25) umfasst, wobei sich der interne Masseplan (25) zwischen der Übertragungsbahn (13) und dem zweiten Masseplan (27) befindet, und dass der zweite Masseplan (27) gegenüber dem Steckplatz (15) fortgesetzt ist.

3. Vorrichtung nach einem der vorangehenden Ansprüche, **dadurch gekennzeichnet, dass** die Übertragungsbahn (13) in der Nähe des Steckplatzes (15) in Zusammenarbeit mit der durch die Übertragung zwischen der zentralen Seele des Verbindungssteckers (11) und dem Steckplatz (15) erzeugten Impedanz eine Filterzelle vom Typ Tiefpass umfasst.

4. Vorrichtung nach Anspruch 3, **dadurch gekennzeichnet, dass** die Filterzelle einen induktiven Leitungsabschnitt (20) und einen kapazitiven Leitungsabschnitt (21) umfasst.

5. Vorrichtung nach einem der vorangehenden Ansprüche, **dadurch gekennzeichnet, dass** der Steckplatz (15) auf einer Achse (zz') zirkulär zentriert ist und dass die Aussparung (26) auf derselben Achse (zz') zirkulär und zentriert ist.

6. Vorrichtung nach Anspruch 5, **dadurch gekennzeichnet, dass** der Durchmesser der Aussparung (26) größer als der des Steckplatzes (15) derart ist, dass die zwischen dem Steckplatz (15) und dem internen Masseplan (25) erzeugte Impedanz begrenzt ist.

7. Vorrichtung nach einem der Ansprüche 1 bis 4, **dadurch gekennzeichnet, dass** der Steckplatz (15) auf einer Achse (zz') zirkulär zentriert ist und dass die Aussparung (26) einen zirkulären Teil (30) umfasst, der auf derselben Achse (zz') zentriert ist, und einen länglichen Teil (31), der sich entlang einer zweiten Achse (32) parallel zu einer Hauptrichtung (33) eines geraden Teils (14) der Übertragungsbahn (13) im Kontakt mit dem Steckplatz (15) erstreckt.

8. Vorrichtung nach Anspruch 7, **dadurch gekennzeichnet, dass** auf dem internen Masseplan (25) eine Projektion der Übertragungsbahn (13) einen im Verhältnis zum Rand der Aussparung (26) etwa konstanten Abstand (d) behält, wobei der Abstand (d) einerseits zwischen dem Steckplatz (15) und dem zirkulären Teil (30) der Aussparung (26) und andererseits zwischen dem geraden Teil (14) der Übertragungsbahn (13) und dem Rand der Aussparung (26) lotrecht zur Hauptrichtung (33) des geraden Teils (14) gemessen wird.

## Claims

1. A connection device for high frequency signals, comprising a printed circuit board (10), on an outer face (12) of which a transmission line (13) is printed, and a coaxial connector (11) mounted on the surface of said printed circuit board (10) on said outer face (12), with the connection of said connector (11) to said printed circuit board (10) being made by bringing together flat zones of said connector (11) on external areas of said printed circuit board that do not have a metallised hole, said transmission line (13) being connected to said connector (11) by means of a contact pad (15) belonging to said transmission line (13), with a central core of said connector (11) being added to said contact pad, said printed circuit board (10) comprising at least one internal ground plane (25) parallel to said outer face (12) and contributing to the matching of said transmission line (13), **characterised in that** said internal ground plane (25) is interrupted by means of a resist (26) opposite said contact pad (15).

2. The device according to claim 1, **characterised in that** said printed circuit board (10) comprises a second ground plane (27) parallel to said internal ground plane (25), said internal ground plane (25) being located between said transmission line (13) and said second ground plane (27), and **in that** said second ground plane (27) is continuous opposite said contact pad (15).

3. The device according to any one of the preceding claims, **characterised in that** said transmission line (13) comprises, in the vicinity of said contact pad (15), a filtering cell of the low-pass type cooperating with the impedance provided by the transition between the central core of said connector (11) and said contact pad (15).

4. The device according to claim 3, **characterised in that** said filtering cell comprises an inductive line section (20) and a capacitive line section (21).

5. The device according to any one of the preceding claims, **characterised in that** said contact pad (15) is circular, centred on an axis (zz'), and **in that** said resist (26) is circular and centred on the same axis (zz').

6. The device according to claim 5, **characterised in that** the diameter of said resist (26) is greater than that of said contact pad (15) so as to limit the impedance generated between said contact pad (15) and said internal ground plane (25).

7. The device according to any one of claims 1 to 4, **characterised in that** said contact pad (15) is circular, centred on an axis (zz'), and **in that** said resist (26) comprises a circular part (30) centred on the same axis (zz') and an extended part (31) extending along a second axis (32) parallel to a main direction (33) of a rectilinear part (14) of said transmission line (13) in contact with said contact pad (15).

8. The device according to claim 7, **characterised in that** on said internal ground plane (25) a projection of said transmission line (13) maintains a distance (d) that is substantially constant relative to the edge of said resist (26), with said distance (d) being measured on the one hand between said contact pad (15) and said circular part (30) of said resist (26) and on the other hand between said rectilinear part (14) of said transmission line (13) and the edge of said resist (26) perpendicular to said main direction (33) of said rectilinear part (14).
